# EUROPÄISCHE PATENTSCHRIFT

(11) **EP 3 114 715 B1**
(45) Veröffentlichungstag und Bekanntmachung des Hinweises auf die Patenterteilung: **30.10.2019**
(21) Anmeldenummer: 15726927.5
(22) Anmeldetag: 28.05.2015
(51) Int. Cl.: H01L 51/54, H01L 51/30, H01L 51/46

(54) **P-DOTIERENDE VERNETZUNG ORGANISCHER LOCHLEITER**
P-DOPING CROSS-LINKING OF ORGANIC HOLE TRANSPORTERS
RÉTICULATION À DOPAGE P DE CONDUCTEURS DE TROUS ORGANIQUES

(30) Priorität: 03.06.2014 DE 102014210412
(43) Veröffentlichungstag der Anmeldung: 11.01.2017
(73) Patentinhaber: Siemens Aktiengesellschaft, 80333 München (DE)
(72) Erfinder: SCHMID, Günter, 91334 Hemhofen (DE); MALTENBERGER, Anna, 91359 Leutenbach (DE); PECQUEUR, Sébastien, F-62136 La Couture (FR)
(86) Internationale Anmeldenummer: PCT/EP2015/061873
(87) Internationale Veröffentlichungsnummer: WO 2015/185440

(56) Entgegenhaltungen:
- US-A1- 2006 093 852
- US-A1- 2014 142 259

## Beschreibung

Die vorliegende Erfindung betrifft ein Verfahren zur Herstellung lochleitender elektrischer Schichten, in dem eine funktionalisierte organische Matrixverbindung mit mindestens einem Vernetzungsreagenz auf einem Substrat unter Ausbildung höhermolekularer Verbindungen zur Reaktion gebracht wird, wobei die funktionalisierte organische Matrixverbindung folgender Formel 1 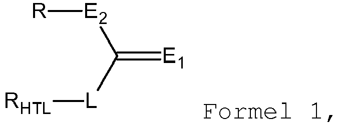 entspricht, wobei
L eine Bindung oder ausgesucht ist aus der Gruppe umfassend substituierte oder nicht substituierte, gesättigte oder ungesättigte C1-C50 Alkyl-, Aryl-, Polyethylenglykol-, Polyethylendiamin-, Polyester-, Polyurethan-, Polyvinylidenphenyl-Ketten oder Mischungen daraus;
E₁, E₂ unabhängig voneinander Sauerstoff, Schwefel, Selen, NH oder NE₃ sein können, wobei E₃ ausgewählt ist aus der Gruppe umfassend substituiertes oder nicht substituiertes Alkyl oder Aryl, wobei E₃ mit R verbunden sein kann;
R ausgesucht ist aus der Gruppe umfassend H, D, C1-C10 Alkyl- oder Aryl-Silylester, fluorierte oder nicht-fluorierte verzweigte oder unverzweigte C1-C10 Alkyl, Aryl oder Heteroaryl, R_{HTL} das Grundgerüst eines organischen Lochleiters ist, und das Vernetzungsreagenz mindestens ein Metallatom aus den Gruppen 13-15 und mindestens einen organischen Liganden umfasst.

### Stand der Technik

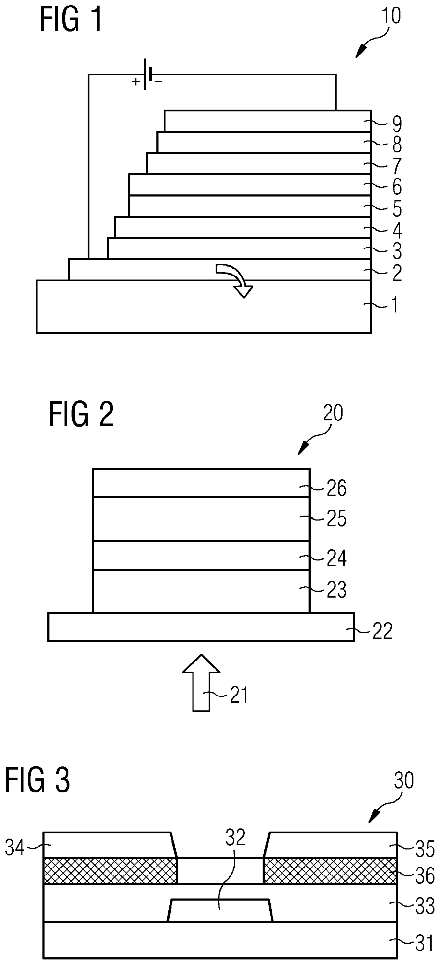

Die kommerziell wichtigsten Bauelemente der organischen Elektronik werden heutzutage im Wesentlichen mittels zweier unterschiedlicher Herstellverfahren erhalten. Eingesetzt werden dabei zum einen Nassprozesse, in welchen organische Schichten durch Abscheiden aus einer Lösung über verschiedene Drucktechniken, wie zum Beispiel Tintenstrahl-, Tief-, Offsetdruck, Spin- oder Slotcoating aufgebaut werden. Zum anderen kann die Abscheidung der Schichten aus der Gasphase heraus mittels Sublimation, also thermischer Verdampfung im Vakuum, erfolgen. Durch Sublimation werden die bisher effizientesten, kommerziell verfügbaren organischen Bauelemente, wie beispielsweise organische lichtemittierende Dioden (siehe Figur 1), Solarzellen (siehe Figur 2), Transistoren (siehe Figur 3) und bipolare Transistoren hergestellt. Die Effizienz dieser Bauteile wird u.a. auch dadurch erreicht, dass diese aus sehr vielen einzelnen Schichten aufgebaut sind, wobei jede der Schichten eine spezielle, auch auf den Ort im Bauteil bezogene, elektrische Funktion besitzt.

Organische Bauelemente, welche durch Lösemittelprozesse hergestellt werden, besitzen zurzeit noch eine deutliche geringere Komplexität im Aufbau. Dies ergibt sich prozessbedingt aufgrund der Anforderung, dass eine abgeschiedene organische Schicht in weiteren Verarbeitungsschritten nicht durch die folgenden, organischen Lösungsmittel angelöst werden darf. Um dieser Randbedingung gerecht zu werden, muss deshalb im weiteren Prozess mit orthogonalen (d.h. nicht mit dem vorherigen Solvent mischbaren) Lösungsmitteln gearbeitet werden. Dies aus dem Grund, damit darunter liegende Schichten nicht wieder angelöst werden. Diese Verfahrensweise limitiert die Anzahl einsetzbarer Lösemittel und die Anzahl verarbeitbarer organischer Substanzen und beschränkt derart die Möglichkeiten und Qualität nassprozesszierbarer Schichtfolgen.

Während oben angegebene Randbedingungen für die Herstellung jedweder elektrisch funktionaler, d.h. blockierender, n- oder p-leitender, organischen Schicht in organischen Bauelementen gilt, ist insbesondere die Herstellung hocheffizienter und langlebiger p-leitender Schichten herausfordernd. Dies in Anbetracht der einzuhaltenden Prozessbedingungen und Auswahl geeigneter Verbindungen, welche ebenjene hohe Funktionalität bei gleichzeitig langen Standzeiten der daraus aufgebauten Bauelemente zeigen müssen.

Ein Weg zur Herstellung effizienter organisch elektronischer Bauteile mit p-dotierten Lochleitern weist zum Beispiel die DE102012209523. In dieser Patentschrift werden organische Bauteile offenbart, welche eine Matrix enthalten, wobei die Matrix als p-Dotand einen Hauptgruppen-Metallkomplex der Gruppen 13 bis 15 enthält. Dieser enthält wiederum mindestens einen Liganden L der folgenden Struktur: 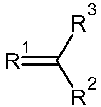
wobei R¹ und R² unabhängig voneinander Sauerstoff, Schwefel, Selen, NH oder NR⁴ sein können, wobei R⁴ ausgewählt ist aus der Gruppe enthaltend Alkyl oder Aryl und mit R³ verbunden sein kann; und
R³ ausgewählt ist aus der Gruppe enthaltend Alkyl, langkettiges Alkyl, Alkoxy, langkettiges Alkoxy, Cycloalkyl, Halogenalkyl, Aryl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogenketoalkyl, Ketoalkenyl, Halogenketoalkenyl, wobei bei geeigneten Resten eine oder mehrere nichtbenachbarte CH₂-Gruppen unabhängig voneinander durch -O-, -S-, -NH-, -CO-, -COO-, -OCO-, -OCO-O-, -SO₂-, -S-CO-, -CO-S-, -CY₁=CY₂ oder -C=C- ersetzt sein können und zwar derart, dass O und/oder S Atome nicht direkt miteinander verbunden sind, ebenfalls optional mit Aryl- oder Heteroaryl bevorzugt enthaltend 1 bis 30 C Atome ersetzt sind.

Ein Verfahren zur Herstellung organisch elektrischer Schichten durch kovalente Verknüpfung organischer Metallkomplexe an eine polymere Matrix wird beispielsweise in der US 2014 014 2259 A1 offenbart.

Des Weiteren wird in der US 2006/0093852 A1 ein Verfahren beschrieben, in welchem phosphoreszente oder lumineszente konjugierte Polymere hergestellt werden, wobei die Emission der Verbindungen auf der Phosphoreszenz kovalent gebundener Metallkomplexe basiert, welche optional durch Fluoreszenz der Polymerkette ergänzt wird.

Nichtsdestotrotz besteht weiterhin Bedarf an Systemen in der organischen Elektronik, welche sich einfach, reproduzierbar und stabil sowohl aus der Nass- wie auch aus der Gasphase prozessieren lassen und die Schichten ergeben, welche unter den thermischen Belastungen im Betrieb daraus resultierender Bauteile eine erhöhte Lebensdauer zeigen können.

Es ist daher die Aufgabe der vorliegenden Erfindung ein verbessertes Verfahren zur Herstellung lochleitender Schichten bereitzustellen, welches sich insbesondere für die Nassherstellung eignet und wobei die resultierenden Schichten eine erhöhte Stabilität aufweisen. Des Weiteren könnte das Grundprinzip des Verfahrens auch für die Herstellung n-leitender Schichten und elektronenblockierender Schichten in organischen Bauelementen Verwendung finden.

Gelöst wird diese Aufgabe durch die Merkmale des Anspruchs 1. Besondere Ausführungsformen der Erfindung werden in den Unteransprüchen wiedergegeben.

Erfindungsgemäß ist ein Verfahren zur Herstellung lochleitender elektrischer Schichten, dadurch gekennzeichnet, dass eine funktionalisierte organische Matrixverbindung mit mindestens einem Vernetzungsreagenz auf einem Substrat unter Ausbildung höhermolekularer Verbindungen zur Reaktion gebracht wird, wobei die funktionalisierte organische Matrixverbindung folgender Formel 1 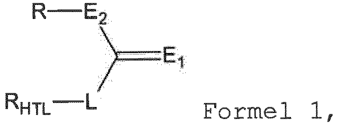 entspricht, wobei
L eine Bindung oder ausgesucht ist aus der Gruppe umfassend substituierte oder nicht substituierte, gesättigte oder ungesättigte C1-C50 Alkyl-, Aryl-, Polyethylenglykol-, Polyethylendiamin-, Polyester-, Polyurethan-, Polyvinylidenphenyl-Ketten oder Mischungen daraus;
E₁, E₂ unabhängig voneinander Sauerstoff, Schwefel, Selen, NH oder NE₃ sein können, wobei E₃ ausgewählt ist aus der Gruppe umfassend substituiertes oder nicht substituiertes Alkyl oder Aryl, wobei E₃ mit R verbunden sein kann;
R ausgesucht ist aus der Gruppe umfassend H, D, C1-C10 Alkyl- oder Aryl-Silylester, fluorierte oder nicht-fluorierte verzweigte oder unverzweigte C1-C10 Alkyl, Aryl oder Heteroaryl, R_{HTL} das Grundgerüst eines organischen Lochleiters ist, und das Vernetzungsreagenz mindestens ein Metallatom aus den Gruppen 13-15 und mindestens einen organischen Liganden umfasst. Es wurde gefunden, dass durch die Reaktion eines erfindungsgemäßen Vernetzungsreagenzes enthaltend mindestens ein Metallatom aus den Gruppen 13-15 mit einem erfindungsgemäß funktionalisiertem Grundgerüst eines organischen Lochleiters, sich dotierte lochleitende Schichten erhalten lassen, welche sich einfacher und reproduzierbarer herstellen lassen und zudem eine deutlich verbesserte Standzeit aufweisen.

Prinzipiell kann dabei das zur Reaktion bringen der funktionalisierten organischen Matrixverbindung mit dem Vernetzungsreagenz ein- oder auch mehrstufig erfolgen. So kann beispielsweise in einem 1. Schritt das Vernetzungsreagenz mit einer 1. funktionalisierten organischen Matrixverbindung zur Reaktion gebracht werden oder reagieren:

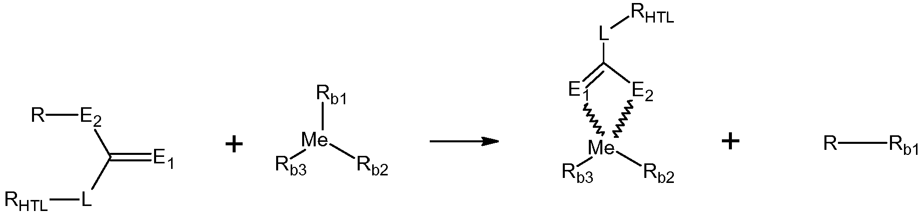

In einem 2. Reaktionsschritt kann dann eine weitere funktionalisierte organische Matrixverbindung an dem Vernetzer gekoppelt werden:

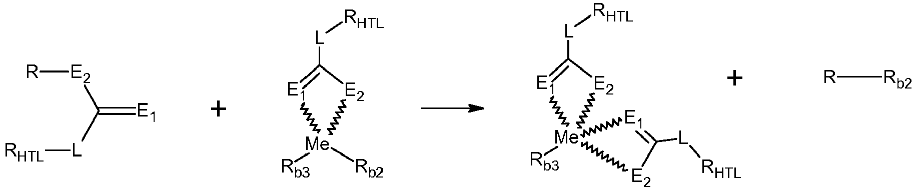

Prinzipiell ist auch eine vollständige Vernetzung durch das Ankoppeln einer 3. funktionalisierten Matrixverbindung möglich:

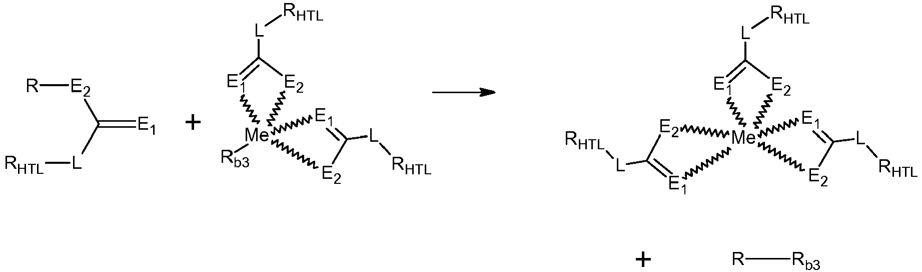

Das zur Reaktion bringen im Sinne der Erfindung wird dabei durch einen der oben dargestellten Zwischenschritte erreicht. Dies bedeutet, dass nicht zwangsläufig immer 3 funktionalisierte organische Matrixverbindungen an einen Vernetzer angekoppelt sein müssen. Auch die Reaktion mit nur einer organischen Matrixverbindung führt schon zu den erfindungsgemäßen Lochleitern. Durch die Reaktion mit der funktionalisierten organischen Matrixverbindung kann rein formal ein Elektron von der organischen Matrixverbindung an den als Lewis-Säure fungierenden Vernetzer abgegeben werden. Durch die Abgabe ändert sich formal die Oxidationszahl des Metallatoms. Durch diesen Prozess können in der organischen Matrixverbindung positive Ladungen erzeugt werden, welche anschließend über das Grundgerüst der Matrixverbindung und weitere Moleküle der Schicht delokalisiert werden können. In dieser Art und Weise wird die Lochleitfähigkeit durch Erhöhung der Zahl der zur Verfügung stehenden Ladungsträger der Schicht erhalten oder gesteigert.

Ohne durch die Theorie gebunden zu sein, kann sich die verbesserte Standzeit der Schichten dadurch ergeben, dass sich durch die Vernetzungsreaktion ein festeres (verknüpftes) Schichtgefüge ergibt, welches weniger zur Kristallisation neigt und insofern eine gegenüber Lösungsmitteln und thermischer Belastung erhöhte Stabilität und damit auch erhöhte Standzeit bei gleichzeitig höherer Leitfähigkeit der Schicht aufweist. Dabei wird erst durch die Reaktion des Vernetzers mit der funktionalisierten organischen Matrix eine feste Verbindung zur organischen Matrix generiert, welche in der Lage ist, die lochleitenden Eigenschaften der Matrix deutlich zu verbessern. Dies kann dadurch erreicht werden, dass im Rahmen der chemischen Vernetzungsreaktion mindestens ein Ligand des Vernetzungsreagenzes abgespalten und diese Koordinationsstelle durch die funktionalisierte Gruppe der organischen Matrixverbindung ersetzt wird. Dieser neue Ligand ist nun erfindungsgemäß kovalent mit dem Grundgerüst des organischen Lochleiters verknüpft. Dies im Gegensatz zu üblichen Verfahrensweisen, nach welchen keine kovalente Verknüpfung eines Liganden des Dotanden mit dem organischen Lochleiter erhältlich ist. Insbesondere hier kann die Ausbildung höhermolekularer Komplexe nach Reaktion des Vernetzers einer Kristallisationsneigung der Schicht entgegenwirken. Zudem ermöglicht die feste Anbindung der Gruppe 13-15 Metallatome an die funktionalisierte organische Matrixverbindung einen weiten Verarbeitungsspielraum im Rahmen von Nassprozessen. Durch die feste Anbindung entfällt die Randbedingung, dass bei dem Auftragen weiterer Schichten mit orthogonalen Lösungsmitteln gearbeitet werden muss. Die feste Verankerung der Metallatome an die Matrixmoleküle verhindert ein Auswaschen derselben, auch wenn die Metallatome prinzipiell in den folgenden Lösungsmitteln löslich gewesen wären. Dadurch wird eine breitere Palette von Lösemitteln im Rahmen des Nassprozesses einsetzbar. Man ist also potenziell in der Lage, das Lösemittel direkt auf die zu lösenden Substanzen abzustimmen, und kann die Gefahr des Auswaschens des Dotanden aus der schon prozessierten Matrix vernachlässigen. Dies führt zu einer deutlich höheren Flexibilität des Prozesses. Desweiteren ist es durch diese Prozessführung möglich, eine deutlich größere Anzahl unterschiedlicher Metallkomplexe in die Matrix einzubinden, da der vernetzende Komplex aus dem Gruppe 13-15 Metall und dem organischen Ligand nicht von vornherein ein klassischer p-Dotand für einen Lochleiter sein muss. Es ist insbesondere denkbar, dass dieser Vernetzer mit den üblichen organischen Matrixmolekülen keine Erhöhung der Lochleitfähigkeit zeigt. Es kann insbesondere erfindungsgemäß sein, dass der Vernetzer erst durch/nach Umsetzung mit der funktionalisierten Matrixverbindung zu einer Erhöhung der Lochleitfähigkeit der Schicht beiträgt, da sich durch Abspaltung eines Liganden und Ankopplung des Grundgerüstes der organischen Matrix über die Funktionalisierung, der neue, dotierende Komplex überhaupt erst bildet. Denkbar ist allerdings auch, dass der Vernetzer als solcher auch schon eine (geringe) intrinsische Erhöhung der Lochleitfähigkeit organischer Matrixverbindungen bewirken kann. Allerdings ergibt sich durch die Umsetzung mit der funktionalisierten Matrix eine im Vergleich zum nicht zur Reaktion gebrachten Vernetzer, deutlich höhere Lochleitfähigkeit der resultierenden Verbindung und damit auch der Schicht. Ohne durch die Theorie gebunden zu sein, eignen sich insbesondere Komplexe mit mindestens einem Gruppe 13-15 Metallatom zur Umsetzung mit der erfindungsgemäß funktionalisierten Matrixverbindung. Dies hochwahrscheinlich deshalb, da diese Metalle mit der erfindungsgemäßen Funktionalisierung aufgrund ihrer Größe und elektrischen Eigenschaften eine besonders schnelle und vollständige Umsetzung zeigen. Dies kann insbesondere zu einer besonders effektiven Herstellung und hoch funktionalen Schichten führen.

Durch die Anbindung des Dotanden an die organische Matrix lassen sich zudem auch Herstellungsweisen denken, in welchen Elemente eines Nass- mit denen eines Vakuumprozesses verbunden werden. So könnte beispielsweise eine 1. Schicht aus Vernetzer und funktionalisierter organischer Matrixverbindung über einen Gasphasenprozess abgeschieden und in einem anschließenden Prozessschritt eine weitere, 2. Schicht durch einen Lösemittelprozess aufgebracht werden. Durch die Reaktion des Vernetzers mit der organischen Matrixverbindung würde verhindert, dass eine Dotierung der 1. Schicht durch das Aufbringen des Lösemittels wieder zerstört würde.

Das oben angegebene Prinzip der in situ-Dotierung kann anhand eines konkreten Beispiels wie folgt dargestellt werden:

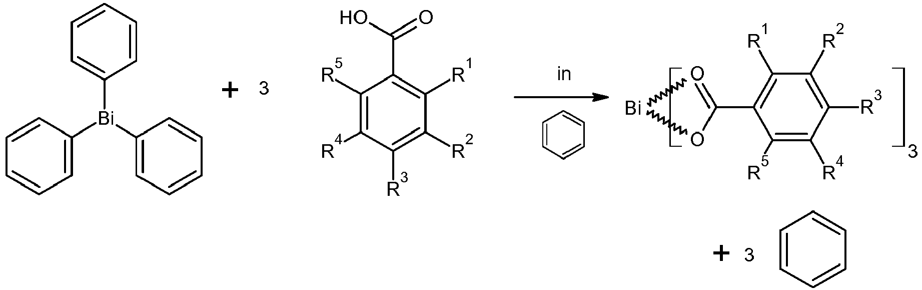

Mindestens einer der Substituenten R¹ - R⁵ steht dabei für das Grundgerüst des organischen Lochleiters, welches über eine kovalente Verknüpfung an die funktionalisierende Gruppe angebunden ist. Die Reaktion muss auch nicht unbedingt zur vollständigen Umsetzung aller Liganden des Vernetzungsreagenzes, also 3fach führen, sondern kann auch so gesteuert werden, dass nur 1 oder 2 Liganden ersetzt werden.

Im obigen Beispiel werden ein Vernetzer und 3 funktionalisierte organische Matrixverbindungen eingesetzt, welche in diesem Beispiel durch eine Carbonsäuregruppe funktionalisiert wurden (E₁=E₂=O, R=H). Die funktionalisierte organische Matrixverbindung kann mit dem Vernetzer unter Verdrängung eines Liganden des Vernetzers reagieren. Dadurch wird eine Verbindung erhalten, welche ein höheres Molekulargewicht aufweist. Durch die Reaktion mit der funktionalisierten organischen Matrixverbindung wird zudem eine Verbindung erhalten, welche lochleitende Eigenschaften aufweist. Insbesondere ist darauf hinzuweisen, dass der Vernetzer als solcher, keine p-dotierenden Eigenschaften aufweisen muss. Die Fähigkeit zur Erhöhung der p-Leitfähigkeit ergibt sich im Wesentlichen erst nach der Reaktion mit der funktionalisierten organischen Matrixverbindung. In diesem Fall entsprechen die Liganden der ursprünglichen Vernetzerverbindung dem Lösungsmittel.

Der Vernetzer wird mit der funktionalisierten organischen Matrixverbindung auf einem Substrat unter Ausbildung höhermolekularer Verbindungen zur Reaktion gebracht. Dabei können die im Bereich der organischen Elektronik üblichen Substrate eingesetzt werden. Dies können zum Beispiel inerte Substrate wie Glas-, Silikon- oder Kunststoffschichten sein. Infrage kommen desweiteren natürlich auch funktionale Schichten, welche vorher durch Nassprozesse oder Sublimationsverfahren aufgebracht wurden. Der Vernetzer und die funktionalisierte organische Matrixverbindung werden dabei derart zur Reaktion gebracht, dass die funktionalisierte organische Matrixverbindung zumindest ein Teil der Koordinationssphäre des Vernetzers, und hier speziell des Metallatoms des Vernetzers, wird. Es erfolgt also prinzipiell ein Ligandenaustausch am Metallatom. Durch die Aufnahme der organischen Matrixverbindung in die Koordinationssphäre des Metallatoms des Vernetzers wird eine Molekulargewichtserhöhung des Vernetzerkomplexes erreicht. Dies im Sinne einer Kondensationsreaktion, wobei, wie im obigen Beispiel gezeigt, Phenylliganden als Benzol abgespalten werden. Die Reaktion des Vernetzers mit der funktionalisierten organischen Matrixverbindung lässt sich z.B. quantitativ über NMR-spektroskopische Methoden erfassen. So bietet sich beispielsweise generell ¹H-NMR und im Falle zum Beispiel des Bismuts als einem möglichen Bestandteil des Vernetzers, die Bestimmung der quantitativen Umsetzung über ein Bismut-NMR an. Weiterhin lässt sich die Reaktion auch über elektrische oder IR-spektroskopische Methoden quantitativ verfolgen.

Die organische Matrixverbindung umfasst also, oder besteht aus einem Grundgerüst eines organischen Lochleiter (R_{HTL}) und mindestens einer funktionalisierenden Gruppe.

In einer bevorzugten Charakteristik des Verfahrens kann das Grundgerüst R_{HTL} des organischen Lochleiters ausgesucht sein aus der Gruppe umfassend C20 - C200 Triarylamin-basierter Lochleiter, Thiophen-haltiger Derivaten davon oder Mischungen daraus. Prinzipiell lassen sich alle dem Fachmann bekannten Lochleiter zur Funktionalisierung einsetzten. Insbesondere können jedoch die C20 - C200 Triarylamin-basierten Lochleiter oder Thiophen-haltigen Derivaten eingesetzt werden. In einer bevorzugten Ausführungsform der Erfindung kann das Grundgerüst des organischen Lochleiter aus C20 - C500 Triarylamin-basierten Lochleitern ausgewählt werden. Eine Beispielverbindung eines thiophen-haltigen Derivaten eines triarylamin-basierten Lochleiters ist beispielsweise N4,N4'-Bis(dibenzo[b,d]thiophen-4-yl)-N4,N4' - diphenylbiphenyl-4,4'-diamin (DBTPB, Cas.-Nr. 1203895-80-0) oder Oligo- oder Polymere daraus.

Als Einheiten im Grundgerüst der funktionalisierten Matrix R_{HTL} eines organischen Lochleiters kommen beispielsweise folgende Verbindungen, oder Mischungen dieser Verbindungen, in Frage:
NPB (N,N'-Bis(naphthalen-1-yl)-N,N'-bis(phenyl)-benzidin),
β-NPB N,N'-Bis(naphthalen-2-yl)-N,N'-bis(phenyl)-benzidin)
TPD (N,N'-Bis(3-methylphenyl)-N,N'-bis(phenyl)-benzidin)
Spiro TPD (N,N'-Bis(3-methylphenyl)-N,N'-bis(phenyl)-benzidin)
Spiro-NPB (N,N'-Bis(naphthalen-1-yl)-N,N'-bis(phenyl)-spiro)
DMFL-TPD N,N'-Bis(3-methylphenyl)-N,N'-bis(phenyl)-9,9-dimethyl-fluoren)
DMFL-NPB (N,N'-Bis(naphthalen-1-yl)-N,N'-bis(phenyl)-9,9-dimethyl-fluoren)
DPFL-TPD (N,N'-Bis(3-methylphenyl)-N,N'-bis(phenyl)-9,9-diphenyl-fluoren)
DPFL-NPB (N,N'-Bis(naphthalen-1-yl)-N,N'-bis(phenyl)-9,9-diphenyl-fluoren)
Spiro-TAD (2,2',7,7'-Tetrakis(N,N-diphenylamino)- 9,9 '-spirobifluoren)
9,9-Bis[4-(N,N-bis-biphenyl-4-yl-amino)phenyl]-9H-fluoren
9,9-Bis[4-(N,N-bis-naphthalen-2-yl-amino)phenyl]-9H-fluoren
9,9-Bis[4-(N,N'-bis-naphthalen-2-yl-N,N'-bis-phenyl-amino)-phenyl]-9H-fluoren
N,N'-bis (phenanthren-9-yl)-N,N'-bis (phenyl)-benzidin
2,7-Bis[N,N-bis(9,9-spiro-bifluorene-2-yl)-amino]-9,9-spirobifluoren
2,2'-Bis[N,N-bis(biphenyl-4-yl)amino]9,9-spiro-bifluoren
2,2'-Bis(N,N-di-phenyl-amino)9,9-spiro-bifluoren
Di-[4-(N,N-ditolyl-amino)-phenyl]cyclohexan
2,2',7,7'-tetra(N, N-di-tolyl)amino-spiro-bifluoren
N, N,N',N'-tetra-naphthalen-2-yl-benzidin. Diese Verbindungen können auch in oligo- oder polymerer Form eingesetzt werden.

Bevorzugterweise können dabei die Oligomere oder Polymere ein Molekulargewicht von größer oder gleich 300 Da und kleiner oder gleich 500 000 Da aufweisen, des Weiteren von größer oder gleich 1000 Da und kleiner oder gleich 250 000 Da. So haben sich beispielsweise oben genannte Lochleiter-Grundgerüste R_{HTL} in diesem Molekulargewichtsbereich als besonders geeignet und zur erfindungsgemäßen Vernetzung als zugänglich erwiesen. Das Molekulargewicht des organischen Lochleiters lässt sich nach den gängigen Methoden zur Molekulargewichtsbestimmung erhalten. An dieser Stelle ist das gewichtsgemittelte Molekulargewicht aufgeführt, welches sich beispielsweise über GPC, Viskosimetrie oder durch andere rheologische Methoden bestimmen lässt. Des Weiteren kommt auch die Lichtstreuung zur Bestimmung des Molekulargewichts in Frage.

Diese Grundgerüste der organischen Matrixverbindung können die funktionalisierende Gruppe an jeder substitutionsfähigen Stelle ihres Grundgerüstes zeigen. Prinzipiell ist es auch möglich, dass diese Grundgerüste mehr als eine funktionalisierende Gruppe aufweisen. Insbesondere kann es vorteilhaft sein, dass die organische Matrixverbindung 0,01-10, bevorzugte weise 0,05-5, des Weiteren bevorzugt 0,1-1 vernetzungsfähige funktionelle Gruppen pro Grundgerüst aufweist. Insbesondere ist bevorzugt, dass die funktionalisierte organische Matrixverbindung eine funktionelle Gruppe trägt.

Das Vernetzungsreagenz umfasst oder besteht aus einem Metall Atom aus den Gruppen 13-15 und mindestens einem durch die erfindungsgemäße funktionalisierte Gruppe abspaltbaren organischen Liganden. Eine Vernetzung mit mehreren funktionalisierten Grundgerüsten kann ab 2 abspaltbaren Liganden auftreten, wobei auch eine einfache Anbindung eines Vernetzers mit nur einem funktionalisierten Grundgerüst erfindungsgemäß ist.

Unter dem Begriff "Metallatom aus den Gruppen 13-15" werden die Metalle der 13. bis 15. Gruppe lt. IUPAC, d.h. Aluminium, Gallium, Indium, Silizium, Germanium, Zinn, Blei, Thallium, Arsen, Antimon, Bismut oder Mischungen daraus verstanden. Bevorzugt sind die Metalle der Gruppe 14 und 15, d.h. Silizium, Germanium, Zinn, Blei, Arsen, Antimon, Bismut.

Der Vernetzer umfasst mindestens einen organischen Liganden. Liganden im Sinne der Erfindung sind dabei niedermolekulare organische Moleküle, welche ungeladen oder geladen vorliegen können, mit einem Molekulargewicht bis zu 250 Dalton. Die niedermolekularen organischen Moleküle können dabei sowohl aliphatisch wie auch aromatisch sein, Heteroatome wie zum Beispiel Sauerstoff oder Schwefel aufweisen, zyklisch oder geradkettig sein.

Im Sinne der vorliegenden Erfindung umfasst oder bedeutet die Bezeichnung "p-Dotand" insbesondere Materialien, die eine Lewis-Azidität aufweisen und/oder in der Lage sind, Komplexe mit dem Matrixmaterial auszubilden, in denen diese Materialien (wenn auch nur formal) Lewis-azid wirken.

Als Linker-Gruppe L der funktionalisierten organischen Matrixverbindung kommen desweiteren beispielhaft in Frage:
a. Aliphatische Ketten wie -(CH₂)ₙ-R wobei n = 1 - 20, bevorzugt n = 1 - 5;
b. Fluorierte Alkylketten mit 1 - 12 Kohlenstoffatomen in der Kette, besonders bevorzugt 6 - 10 Kohlenstoffatomen;
c. Ungesättigte Alkylketten mit 1 - 20 Kohlenstoffatomen und konjugierten bzw. nicht-konjugierten Doppelbindungen;
d. Ungesättigte Alkylketten mit 1 - 20 Kohlenstoffatomen und konjugierten bzw. nicht-konjugierten Dreifachbindungen, auch in Verbindung mit Aromaten;
e. Anstelle einer Alkylkette kann auch eine Polyethylenglykol-, Polyethylendiamin¬-, Polyester-, Polyurethan-, Polyvinylidenphenylenkette Verwendung finden;
f. Ketten, die Aromaten oder Polyene für eine leitende Kopplung enthalten;
g. Gemischte Varianten aus a - g.

In einer besonderen Ausführungsform des Verfahrens können E₁ und E₂ aus Formel 1 Sauerstoff sein. Carbonsäuren oder die Carboxylate haben sich im Rahmen des erfindungsgemäßen Verfahrens als besonders geeignet erwiesen, um mit dem erfindungsgemäß einsetzbaren Vernetzer zu reagieren. Insbesondere die Carbonsäuren oder Carboxylate als funktionelle Gruppen der organischen Matrixverbindung können durch Reaktion mit dem Vernetzer zu besonders temperatur- und gegenüber Lösemitteln stabilen Schichten führen. Ohne durch die Theorie gebunden zu sein, entsteht dabei ein Metall-Carboxylat-Komplex, der Lewis-Säure aktiv ist und besonders gut mit dem Grundgerüst der organischen Matrixverbindung wechselwirken kann. Dadurch lassen sich besonders stabile p-leitende Schichten erhalten, in denen das Metallatom besonders fest, weil koordinativ, an die organische Matrixverbindung gebunden ist, so dass zum Beispiel im Rahmen weiterer Nassprozesse kein Dotand aus den vorhergehenden Schichten gelöst werden kann. Desweiteren scheinen die Carboxylate und Carbonsäuren als funktionelle Gruppe besonders geeignet zu sein, um eine schnelle und vollständige Umsetzung mit dem Vernetzer zu ermöglichen.

In einer weiteren Ausgestaltung des Verfahrens kann das Vernetzungsreagenz Metallatome aus der Gruppe bestehend aus Bismut, Zinn, Blei oder Mischungen daraus umfassen. Es hat sich gezeigt, dass insbesondere Bismut, Zinn und Blei oder Mischungen daraus in der Lage sind, schnell und vollständig mit der funktionalisierten organischen Matrixverbindung zu reagieren und derart höhermolekulare Verbindungen auszubilden. Demzufolge können diese Metallatome dann auch durch weitere Lösungsmittel nur schwer wieder aus der organischen Matrixverbindung herausgelöst werden. Dies kann zu einer besseren Herstellbarkeit der erfindungsgemäßen Schichten durch zum Beispiel Nassprozesse führen. Diese Metallatome können zudem durch ihre Elektronenkonfiguration und Lewis-Acidität in höhermolekularen Komplexen eine besonders gute Lochleitung der resultierenden Schichten induzieren.

In einer alternativen Ausführungsmöglichkeit des Verfahrens kann das Vernetzungsreagenz Bismut oder Zinn umfassen und mindestens ein Ligand des Vernetzungsreagenzes ausgesucht sein aus der Gruppe umfassend substituierte oder nicht substituierte C1-C200 Aryl, Alkyl, Alkoxy, Cycloalkyl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogenketoalkyl, Ketoalkenyl, Halogenketoalkenyl, wobei bei geeigneten Resten eine oder mehrere nicht benachbarte CH₂-Gruppen unabhängig voneinander durch -O-, -S-, -NH-, -CO-, -COO-, -OCO-, - OCO-O-, -SO₂-, -S-CO-, -CO-S-, -C=C- oder -C=C- ersetzt sein können und zwar derart, dass O und/oder S Atome nicht direkt miteinander verbunden sind. Insbesondere Zinn und Bismut haben sich aufgrund ihrer Verfügbarkeit, Umweltverträglichkeit und ihren elektronischen Eigenschaften als besonders geeignet zur Herstellung p-leitender Schichten erwiesen. Des Weiteren können insbesondere Komplexe dieser Metalle mit den aufgeführten Substituenten zu Vernetzern führen, welche mit den erfindungsgemäß funktionalisierten organischen Matrixmolekülen sich besonders schnell und vollständig umsetzen. Dadurch lassen sich besonders stabile p-leitende Schichten erhalten. Ohne durch die Theorie gebunden zu sein, ergibt sich die schnelle und vollständige Umsetzung mit den funktionalisierten Matrixverbindungen durch die spezielle sterische und elektronische Ausgestaltung der Substituenten. Des Weiteren können diese Substituenten auch zu einer geeigneten Lewis-Acidität des Vernetzers führen, welche auch zu einer schnellen und vollständigen Umsetzung des Vernetzers mit der funktionalisierten organischen Matrixverbindung beitragen kann. Insbesondere kann es sich bei den oben genannten Liganden um Liganden handeln, welche durch die Reaktion mit der funktionalisierten organischen Matrix aus dem Vernetzungsreagenz abgespalten werden können.

In einer zusätzlichen Ausgestaltung des Verfahrens kann das Grundgerüst eines organischen Lochleiters ausgesucht sein aus der Gruppe umfassend oder bestehend aus PEDOT (Poly(3,4-ethylendioxythiophen)), PVK (Poly(9-vinylcarbazol)), PTPD (Poly(N,N'-bis(4-butylphenyl)-N,N'-bis(phenyl)benzidin), PANI (Polyanilin), P3HT(Poly(3-hexylthiophen)) oder Mischungen daraus. Es hat sich gezeigt, dass sich gerade diese Gruppe an organischen Lochleitern im Rahmen dieses erfindungsgemäßen Verfahrens besonders gut prozessieren lassen. Dies gilt speziell für die Vernetzung dieser funktionalisierten Grundgerüste im Rahmen von Nassprozessen. Diese im Nassprozess hergestellten p-leitenden Schichten können eine besonders hohe p-Leitfähigkeit aufweisen und daraus hergestellte Schichten können über die erfindungsgemäße Vernetzung eine besonders hohe Standzeit zeigen.

In einer weiteren Ausgestaltung des erfindungsgemäßen Verfahrens können die Einheiten im Grundgerüst der funktionalisierten Matrix R_{HTL} eines organischen Lochleiters ausgesucht sein aus folgenden Verbindungen oder Mischungen dieser Verbindungen: NPB (N,N'-Bis(naphthalen-1-yl)-N,N'-bis(phenyl)-benzidin), β-NPB N,N'-Bis(naphthalen-2-yl)-N,N'-bis(phenyl)-benzidin), TPD (N,N'-Bis(3-methylphenyl)-N,N'-bis(phenyl)-benzidin), Spiro TPD (N,N'-Bis(3-methylphenyl)-N,N'-bis(phenyl)-benzidin), Spiro-NPB (N,N'-Bis(naphthalen-1-yl)-N,N'-bis(phenyl)-spiro), DMFL-TPD N,N'-Bis(3-methylphenyl)-N,N'-bis(phenyl)-9,9-dimethyl-fluoren), DMFL-NPB (N,N'-Bis(naphthalen-1-yl)-N,N'-bis(phenyl)-9,9-dimethyl-fluoren) DPFL-TPD (N,N'-Bis(3-methylphenyl)-N,N'-bis(phenyl)-9,9-diphenyl-fluoren), DPFL-NPB (N,N'-Bis(naphthalen-1-yl)-N,N'-bis(phenyl)-9,9-diphenyl-fluoren), Spiro-TAD (2,2',7,7'-Tetrakis(N,N-diphenylamino)- 9,9 '-spirobifluoren), 9,9-Bis[4-(N,N-bis-biphenyl-4-yl-amino)phenyl]-9H-fluoren, 9,9-Bis[4-(N,N-bis-naphthalen-2-yl-amino)phenyl]-9H-fluoren, 9,9-Bis[4-(N,N'-bis-naphthalen-2-yl-N,N'-bis-phenyl-amino)-phenyl]-9H-fluoren, N,N'-bis(phenanthren-9-yl)-N,N'-bis(phenyl)-benzidin, 2,7-Bis[N,N-bis(9,9-spiro-bifluorene-2-yl)-amino]-9,9-spiro-bifluoren, 2,2'-Bis[N,N-bis(biphenyl-4-yl)amino]9,9-spiro-bifluoren, 2,2'-Bis(N,N-di-phenyl-amino)9,9-spiro-bifluoren, Di-[4-(N,N-ditolyl-amino)-phenyl]cyclohexan, 2,2',7,7'-tetra(N, N-di-tolyl)amino-spirobifluoren, N, N,N',N'-tetra-naphthalen-2-yl-benzidin. Diese Einheiten im Grundgerüst des organischen Lochleiters zeigen gute lochleitende Eigenschaften und lassen sich zudem zielgenau im Sinne der Erfindung funktionalisieren. Einsetzbar sind die Monomere, Mischungen der Monomore, Oligo- oder Polymere einer einzelnen oder Oligo- oder Polymere mehrerer Monomerspezies.

In einer weiteren Ausgestaltung des erfindungsgemäßen Verfahrens können auch elektronenblockierende Schichten hergestellt werden. Dazu kann es zweckmäßig sein, eine oder mehrere elektronenleitende Verbindungen ausgewählt aus der Gruppe umfassend oder bestehend aus 2,2',2" -(1,3,5-Benzinetriyl)-tris(1-phenyl-1-H-benzimidazole), 2-(4-Biphenylyl)-5-(4-tert-butylphenyl)-1,3,4-oxadiazole, 2,9-Dimethyl-4,7-diphenyl-1,10-phenanthroline, 8-Hydroxyquinolinolato-lithium, 4-(Naphthalen-1-yl)-3,5-diphenyl-4H-1,2,4-triazole, 1,3-Bis[2-(2,2'-bipyridine-6-yl)-1,3,4-oxadiazo-5-yl]benzene, 4,7-Diphenyl-1,10-phenanthroline, 3-(4-Biphenylyl)-4-phenyl-5-tert-butylphenyl-1,2,4-triazole, Bis(2-methyl-8-quinolinolate)-4-(phenylphenolato)aluminium, 6,6'-Bis[5-(biphenyl-4-yl)-1,3,4-oxadiazo-2-yl]-2,2'-bipyridyl, 2-phenyl-9,10-di(naphthalen-2-yl)-anthracene, 2,7-Bis[2-(2,2'-bipyridine-6-yl)-1,3,4-oxadiazo-5-yl]-9,9-dimethylfluorene, 1,3-Bis[2-(4-tert-butylphenyl)-1,3,4-oxadiazo-5-yl]benzene, 2-(naphthalen-2-yl)-4,7-diphenyl-1,10-phenanthroline, 2,9-Bis(naphthalen-2-yl)-4,7-diphenyl-1,10-phenanthroline, Tris(2,4,6-trimethyl-3-(pyridin-3-yl)phenyl)borane, 1-methyl-2-(4-(naphthalen-2-yl)phenyl)-1H-imidazo[4,5-f][1,10]phenanthroline erfindungsgemäß zu funktionalisieren und zusammen mit dem erfindungsgemäßen Vernetzer zur Reaktion zu bringen. Auf diese Art und Weise lassen sich stabile Elektronen blockierenden Schichten erhalten. Das Verfahren ist sowohl im Rahmen von Nassprozessen wie auch im Rahmen von Gasphasenabscheidung anwendbar und kann insbesondere zur Herstellung hocheffizienter OLEDs eingesetzt werden.

Gemäß einer weiteren Ausgestaltung des erfindungsgemäßen Verfahrens kann das Vernetzungsreagenz mindestens einen Substituenten nach folgender Formel 2 enthalten 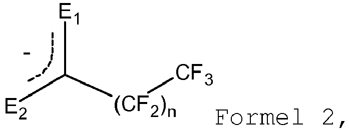 wobei n = 0-20. In der Formel 2 kann zudem jedes Fluoratom unabhängig voneinander durch substituierte oder unsubstituierte Heterozyklen ersetzt sein. Vorzugsweise können die Substituenten aus substituierten und unsubstituierten Heterocyclen wie z.B. Furan, Thiophen, Pyrrol, Oxazol, Thiazol, Imidazol, Isoxazol, Isothazol, Pyrazol, Pyridin, Pyrazin, Pyrimidin, 1,3,6 Triazin, Pyrylium, alpha-Pyrone, gamma-Pyrone, Benzofuran, Benzothiophen, Indol 2H-Isoindol, Benzothiazol,2-benzothiophene, 1H-benzimidazole, 1H-benzotriazole, 1,3 benzoxazole, 2-benzofuran, 7H-purine, Chinolin, Iso-Chinolin, Quinazoline, Quinoxaline, phthalazine, 1,2,4-benzotriazine, Pyrido[2,3-d]pyrimidine, Pyrido[3,2-d]pyrimidine, pteridine, acridine, phenazine, benzo[g]pteridine, 9H-carbazole und Bipyridin und deren Derivaten ausgewählt werden. Diese Struktur mindestens eines Liganden des Vernetzungsreagenzes hat sich für das erfindungsgemäße Verfahren als besonders geeignet erwiesen. Ohne durch die Theorie gebunden zu sein, verändern die Liganden die Lewis-Acidität des Metalls, so dass dadurch die Umsetzungsgeschwindigkeit und die Vollständigkeit der Umsetzung gesteuert werden kann. In einer Ausführungsform der Erfindung ist die Anzahl der Liganden nach Formel 2 auf maximal 2 Liganden am Metallatom begrenzt.

In einem weiteren Aspekt des erfindungsgemäßen Verfahrens kann die Vernetzung der funktionalisierten organischen Matrixverbindung mit dem Vernetzungsreagenz auch durch die Zugabe von Oxidationsmitteln katalysiert werden. So kann beispielsweise eine funktionalisierte organische Matrixverbindung mittels Wasserstoffperoxid an ein Bismut enthaltenden Vernetzer angekoppelt werden. Das folgende Reaktionsschema ist dabei nur beispielhaft zu verstehen:

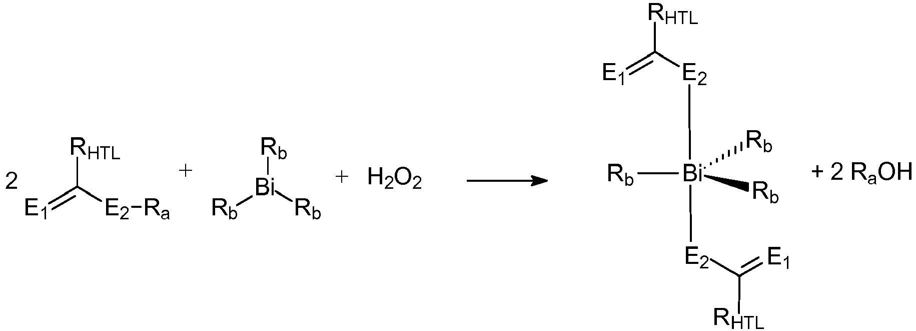

Anstelle des Bismuts kann das Vernetzungsreagenz natürlich auch die anderen Metalle der Gruppen 13-15 enthalten. Desweiteren ist die organische Matrixverbindung ohne Linker Gruppe L dargestellt. Neben Wasserstoffperoxid, kommen natürlich auch andere, dem Fachmann geläufige, Oxidationsmittel in Betracht. Durch den Zusatz des Oxidationsmittels lassen sich in geeigneten Fällen die Reaktionsgeschwindigkeiten und der Grad der Umsetzung günstig beeinflussen.

In einer weiteren, bevorzugten Ausgestaltung des Verfahrens, kann das Vernetzungsreagenz Bismut oder Zinn umfassen und mindestens einen Substituenten mit nachfolgender Struktur enthalten: 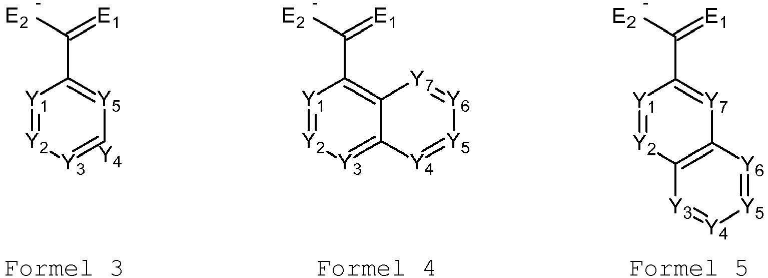 wobei Yₘ mit m von 1-7 unabhängig voneinander ausgesucht sein können aus der Gruppe umfassend C-H, C-D, C-F, C-CF₃, C-NO₂, C-CN, C-Cl, C-Br, C-CN₃, C-OCN, C-NCO, C-CNO, C-SCN, C-NCS, C-SeCN. Diese Liganden am Vernetzungsreagenz haben sich zur Umsetzung mit der funktionalisierten organischen Matrixverbindung als besonders geeignet erwiesen. Dies hochwahrscheinlich aufgrund ihrer sterischen Ausgestaltung und durch die besondere Fähigkeit, mittels des gewählten Substitutionsmusters die Lewis-Acidität des Vernetzers zu steuern. Auf diese Art und Weise ist man in der Lage, die Reaktionsgeschwindigkeit und die Vollständigkeit der Umsetzung mit zu beeinflussen.

In einer weiteren erfindungsgemäßen Ausgestaltung kann das Vernetzungsreagenz Bismut oder Zinn enthalten und mindestens einer seiner Substituent ausgewählt sein aus der Gruppe umfassend oder bestehend aus 2,6-difluorobenzoat, 4-fluorobenzoat, 3-fluorobenzoat, 3,5-difluorobenzoat, 3,4,5-trifluorobenzoat, 3,5-bis(trifluoromethyl)benzoat, perfluorobenzoate, 4-perfluorotoluat oder Mischungen daraus.

In einem zusätzlichen Aspekt der Erfindung kann das Vernetzungsreagenz mindestens einen Substituenten umfassen, welcher ausgewählt ist aus der Gruppe:
- fluorierte Benzoate
   wie z.B. 2-(Trifluoromethyl)benzoat; 3,5-Difluorobenzoat; 3-Hydroxy-2,4,6-triiodobenzoat; 3-Fluoro-4-methylbenzoat; 3-(Trifluoromethoxy)benzoat; 4-(Trifluoromethoxy)benzoat; 4-Chloro-2,5-difluorobenzoat; 2-Chloro-4,5-difluorobenzoat; 2,4,5-Trifluorobenzoat; 2-Fluorobenzoat; 4-Fluorobenzoat; 2,3,4-Trifluorobenzoat; 2,3,5-Trifluorobenzoat; 2,3-Difluorobenzoat; 2,4-Bis(trifluoromethyl)benzoat; 2,4-Difluorobenzoat; 2,5-Difluorobenzoat; 2,6-Bis(trifluoromethyl)benzoat; 2,6-Difluorobenzoat; 2-Chloro-6-fluorobenzoat; 2-Fluoro-4-(trifluoromethyl)benzoat; 2-Fluoro-5-(trifluoromethyl)benzoat; 2-Fluoro-6-(trifluoromethyl)benzoat; 3,4,5-Trifluorobenzoat; 3,4-Difluorobenzoat; 3,5-Bis(trifluoromethyl)benzoat; 3-(Trifluoromethyl)benzoat; 3-Chloro-4-fluorobenzoat; 3-Fluoro-5-(trifluoromethyl)benzoat; 3-Fluorobenzoat; 4-Fluoro-2-(trifluoromethyl)benzoat; 4-Fluoro-3-(trifluoromethyl)benzoat; 5-Fluoro-2-methylbenzoat; 2-(Trifluoromethoxy)benzoat; 2,3,5-Trichlorobenzoat; 4-(Trifluoromethyl)benzoat; Pentafluorobenzoat; 2,3,4,5-Tetrafluorobenzoat; 2,3,5,6-Tetrafluoro-4-(trifluoromethyl)benzoat;
- fluorierte oder nicht-fluorierte Phenylacetate
   wie z.B. 2-Fluor-Phenylacetat; 3-Fluor-Phenylacetat; 4-Fluor-Phenylacetat; 2,3-Difluor-Phenylacetat; 2,4-Difluor-Phenylacetat; 2,6-Difluor-Phenylacetat; 3,4-Difluor-Phenylacetat; 3,5-Difluor-Phenylacetat; Pentafluor-Phenylacetat; 2-Chloro-6-fluor-Phenylacetat; 2-Chloro-3,6-difluor-Phenylacetat; 3-Chloro-2,6-difluor-Phenylacetat; 3-Chloro-4-fluor-Phenylacetat; 5-Chloro-2-fluor-Phenylacetat; 2,3,4-Trifluor-Phenylacetat; 2,3,5-Trifluor-Phenylacetat; 2,3,6-Trifluor-Phenylacetat; 2,4,5-Trifluor-Phenylacetat; 2,4,6-Trifluor-Phenylacetat; 3,4,5-Trifluor-Phenylacetat; 3-Chloro-2-fluor-Phenylacetat; α-Fluor-Phenylacetat; 4-Chloro-2-fluor-Phenylacetat; 2-Chloro-4-fluor-Phenylacetat; α,α-Difluor-Phenylacetat; Ethyl 2,2-Difluor-2-phenylacetate;
- fluorierte oder nicht-fluorierte Acetate
   wie z.B. Methyl-trifluoroacetat; Allyl-trifluoroacetat; Ethyl-trifluoroacetat; Isopropyl-trifluoroacetat; 2,2,2-Trifluoroethyl-trifluoroacetat; Difluoroacetat; Trifluoroacetat; Methyl-chlorodifluoroacetat; Ethylbromodifluoroacetat; Chlorodifluoroacetat; Ethylchlorofluoroacetat; Ethyl-difluoroacetat; (3-Chlorophenyl)-difluoracetat; (3,5-Difluorophenyl)-difluoroacetat; (4-Butylphenyl)difluoroacetat; (4-tert-Butylphenyl)difluoroacetat; (3,4-Dimethylphenyl)-difluoroacetat; (3-Chloro-4-fluorophenyl)-difluoroacetat; (4-Chlorophenyl)-difluoroacetat; 2-Biphenyl-3',5'-difluoroacetat; 3-Biphenyl-3',5'-difluoroacetat; 4-Biphenyl-3',5'-difluoroacetat; 2-Biphenyl-3',4'-difluoroacetat; 3-Biphenyl-3',4'-difluoroacetat; 4-Biphenyl-3',4'-difluoroacetat und 2,2-Difluoro-propionat.

Diese Liganden an dem Vernetzungsreagenz haben sich zur schnellen Umsetzung als besonders geeignet erwiesen. Es lassen sich bei kurzen Prozesszeiten hocheffiziente lochleitende Schichten erhalten. Es können auch die höheren Homologen dieser Verbindungen eingesetzt werden. Es kann vorteilhafterweise auch jeder Ligand des Vernetzers aus oben angegebenen Verbindungen ausgesucht werden. Es kann zudem auch vorteilhaft sein, dass jeder Ligand des Vernetzungsreagenzes nur einer der oben angegeben Verbindungen entspricht.

Innerhalb einer bevorzugten Ausführungsform des Verfahrens kann das Vernetzungsreagenz ein substituierter oder nicht substituierter Triaryl-Bismutkomplex sein. Insbesondere die symmetrische Wahl der Liganden des Vernetzungsreagenzes, welches Bismut enthält, mit Arylen hat sich im Rahmen des erfindungsgemäßen Verfahrens als besonders geeignet erwiesen. Ohne durch die Theorie gebunden zu sein, könnte sich dies insbesondere dadurch ergeben, dass die Aryle sich durch die funktionalisierte organische Matrixverbindung besonders leicht abspalten lassen. Vorteilhafterweise ergibt sich zudem, dass man als Austrittsgruppe Benzol, Toluol oder Xylol erhält, welches zudem häufig als Lösungsmittel in Nassprozessen eingesetzt wird.

In einer zusätzlichen Charakteristik des Verfahrens kann die funktionalisierte organische Matrixverbindung einen weiteren Anteil von größer oder gleich 0 Gewichts-% und kleiner oder gleich 50 Gewichts-% nicht funktionalisierter Matrixverbindung umfassen. Im Rahmen der erfindungsgemäßen Ausgestaltung des Verfahrens kann es zweckdienlich sein, dass nicht die gesamte Menge an organischer Matrixverbindung funktionalisiert wird bzw. nicht-funktionalisierte Matrixverbindungen hinzu gemischt werden. Mittels dieses Anteils an nicht funktionalisierter organischer Matrixverbindung können zum Beispiel bestimmte Eigenschaften der p-leitenden Schicht wie beispielsweise das Aufwachs- oder Kristallisationsverhalten beeinflusst werden. Es können bevorzugt größer oder gleich 0 Gewichts-% und kleiner oder gleich 20 Gewichts-% und des Weiteren bevorzug größer oder gleich 0 Gewichts-% und kleiner oder gleich 10 Gewichts-% nicht-funktionalisierter organischer Matrixverbindung hinzugesetzt werden.

In einem zusätzlichen Aspekt des Verfahrens kann das Vernetzungsreagenz und die organische Matrixverbindung mittels einer Temperaturbehandlung in einem Bereich von größer oder gleich 50°C und kleiner oder gleich 300°C auf dem Substrat zur Reaktion gebracht werden. Zur sicheren und vollständigen Umsetzung des Vernetzungsreagenzes mit der funktionalisierten organischen Matrixverbindung kann es vorteilhaft sein, mittels einer Temperaturbehandlung in oben angegebenen Temperaturbereich eine schnellere und vollständige Reaktion herbeizuführen. Dies kann sich zudem vorteilhaft auf die Prozessökonomie auswirken. Des Weiteren kann diese Temperaturbehandlung genutzt werden, um im Rahmen eines Nassprozesses das Lösemittel zu entfernen. Auf diese Art und Weise erhält man mit einem geringen Energieaufwand sowohl das Entfernen des Lösungsmittels wie auch eine schnelle Umsetzung der Vernetzung. Zudem ist im Sinne der Erfindung ein organisch elektrisches Bauteil umfassend mindestens eine lochleitende elektrische Schicht, hergestellt nach dem erfindungsgemäßen Verfahren. Insbesondere in organisch elektrischen Bauteilen lassen sich die erfindungsgemäßen lochleitenden Schichten besonders vorteilhaft einsetzen. Zum einen ermöglicht die vorgestellte Prozessführung eine höchst effiziente und kostengünstige Herstellung und zum anderen werden durch die feste Anbindung des Dotanden an die organische Matrix besonders langlebige und lösungsmittelresistente p-leitfähige Schichten erhalten. Dies kann in einem hohen Maße zur Ausfallsicherheit und guten Weiterprozesszierbarkeit der so erhältlichen Bauelemente beitragen.

Insbesondere lassen sich die nach dem erfindungsgemäßen Verfahren hergestellten Schichten in Bauteilen wie organischen Solarzellen, organischen Transistoren, licht-emittierenden organischen Bauteilen, organischen Leuchtdioden und/oder organisch licht-emittierenden elektrochemischen Zellen verwenden. Das beschriebene Verfahren und die damit herstellbaren, funktionalisierten Schichten können entsprechend für absorbierende Bauelemente wie Photodioden oder Solarzellen Verwendung finden. Insbesondere eignet sich das erfindungsgemäße Verfahren auch zur Herstellung bipolarer Transistoren. Das Verfahren ist mit den Standard-Herstellungsschritten dieser Bauelemente kompatibel und derart lassen sich kostengünstig, langlebige und effiziente Bauelemente erhalten.

Hinsichtlich weiterer Vorteile und Merkmale der vorbeschriebenen organischen Halbleiterbauelemente wird hiermit explizit auf die Erläuterungen im Zusammenhang mit der erfindungsgemäßen Verwendung sowie dem erfindungsgemäßen Verfahren verwiesen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Der Schichtaufbau von Bauelementen für die organische Elektronik wird nachfolgend anhand von Figuren näher erläutert. Die Figuren zeigen
- Fig. 1: schematisch den Aufbau einer organischen Leuchtdiode (10). Die Leuchtdiode ist aufgebaut aus einer Glas-Schicht (1); Silikon- oder Indium-Zinn-Oxid (ITO)-Schicht (2); Loch-Injektor-Schicht (3); Loch-Transportschicht (HTL) (4); Emitter-Schicht (EML) (5); Loch-Blocker-Schicht (HBL) (6); Elektronen-Transportschicht (ETL) (7); Elektronen-Injektorschicht (8)und einer Kathoden-Schicht (9);
- Fig. 2: schematisch den Aufbau einer organischen Solarzelle mit PIN-Struktur (20), welche Licht (21) in elektrischen Strom umwandelt. Die Solarzelle besteht aus einer Schicht aus Indium-Zinn-Oxid (22); einer p-dotierten Schicht(23); einer Absorptions-Schicht (24); einer n-dotierten Schicht (25) und einer Metall-Schicht (26);
- Fig. 3: schematisch einen möglichen Querschnitt eines organischen Feld-Effekt-Transistors (30). Auf einem Substrat (31) ist eine Gate-Elektrode (32), ein Gate-Dielektrikum (33), ein Source und Drain-Kontakt (34 + 35) und ein organischer Halbleiter (36) aufgebracht. Die schraffierten Stellen zeigen die Stellen an denen eine Kontaktdotierung hilfreich ist.

### Beispiele:

Die Abscheidung und Vernetzung der Schicht kann sequentiell oder innerhalb desselben Arbeitsschrittes erfolgen. Auch sind Vakuum- und Nassprozesse kombinierbar. Im Folgenden werden einige Ausführungsformen genannt, die prinzipiell kombinierbar bzw. erweiterbar sind:
a. Carbonsäure-funktionalisierte Lochleiter (oligomer oder niedermolekular) werden im Vakuum zusammen mit einem Bienthaltenden Vernetzer aufgedampft. Im Anschluss wird die Schicht bei 80 - 300°C getempert. Man erhält eine vollständige Vernetzung.
b. Carbonsäure-funktionalisierte Lochleiter (oligomer oder niedermolekular) werden im Vakuum allein aufgedampft. Anschließend wird die Schicht dem Dampf oder einer Lösung des Vernetzers ausgesetzt, um die Vernetzung dann durch Temperatur oder Licht gestartet auszuführen.
c. Carbonsäure-funktionalisierte Lochleiter (oligomer oder niedermolekular) werden aus Lösung zusammen mit dem Vernetzerreagenz abgeschieden. Im Anschluss wird die Schicht bei 80 - 300 °C getempert.
d. Carbonsäure-funktionalisierte Lochleiter (oligomer oder niedermolekular) werden aus Lösung allein abgeschieden. Anschließend wird die Schicht dem Dampf oder einer Lösung des Vernetzers ausgesetzt, um die Vernetzung dann durch Temperatur oder Licht gestartet auszuführen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung laut Ansprüchen zu verlassen.

## Patentansprüche

1. Verfahren zur Herstellung lochleitender elektrischer Schichten, wobei eine funktionalisierte organische Matrixverbindung mit mindestens einem Vernetzungsreagenz auf einem Substrat unter Ausbildung höhermolekularer Verbindungen zur Reaktion gebracht wird, wobei das Vernetzungsreagenz mindestens ein Metallatom aus den Gruppen 13-15 und mindestens einen organischen Liganden umfasst, **dadurch gekennzeichnet, dass** die funktionalisierte organische Matrixverbindung folgender Formel 1 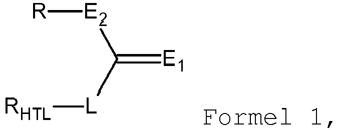 entspricht, wobei
L eine Bindung oder ausgesucht ist aus der Gruppe umfassend substituierte oder nicht substituierte, gesättigte oder ungesättigte C1-C50 Alkyl-, Aryl-, Polyethylenglykol-, Polyethylendiamin-, Polyester-, Polyurethan-, Polyvinylidenphenyl-Ketten oder Mischungen daraus;
E₁, E₂ unabhängig voneinander Sauerstoff, Schwefel, Selen, NH oder NE₃ sein können, wobei E₃ ausgewählt ist aus der Gruppe umfassend substituiertes oder nicht substituiertes Alkyl oder Aryl, wobei E₃ mit R verbunden sein kann;
R ausgesucht ist aus der Gruppe umfassend H, D, C1-C10 Alkyl- oder Aryl-Silylester, fluorierte oder nicht-fluorierte verzweigte oder unverzweigte C1-C10 Alkyl, Aryl oder Heteroaryl,
R_{HTL} das Grundgerüst eines organischen Lochleiters ist.

2. Verfahren nach Anspruch 1, wobei E₁ und E₂ aus Formel 1 Sauerstoff sind.

3. Verfahren nach Anspruch 1 oder 2, wobei das Vernetzungsreagenz Metallatome aus der Gruppe bestehend aus Bismut, Zinn, Blei oder Mischungen daraus umfasst.

4. Verfahren nach einem der Ansprüche 1-3, wobei das Vernetzungsreagenz Bismut oder Zinn umfasst und mindestens ein Ligand des Vernetzungsreagenzes ausgesucht ist aus der Gruppe umfassend substituierte oder nicht substituierte C1-C200 Aryl, Alkyl, Alkoxy, Cycloalkyl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogenketoalkyl, Ketoalkenyl, Halogenketoalkenyl, wobei bei geeigneten Resten eine oder mehrere nicht benachbarte CH₂-Gruppen unabhängig voneinander durch -O-, -S-, - NH-, -CO-, -COO-, -OCO-, -OCO-O-, - SO₂-, -S-CO-, -CO-S-, -C=C- oder -C=C- ersetzt sein können und zwar derart, dass O und/oder S Atome nicht direkt miteinander verbunden sind.

5. Verfahren nach einem der Ansprüche 1-4, wobei das Grundgerüst des organischen Lochleiters ausgesucht ist aus der Gruppe umfassend PEDOT (Poly(3,4-ethylendioxythiophen)), PVK (Poly(9-vinylcarbazol)), PTPD (Poly(N,N'-bis(4-butylphenyl)-N,N'-bis(phenyl)benzidin), PANI (Polyanilin), P3HT(Poly(3-hexylthiophen)) oder Mischungen daraus.

6. Verfahren nach einem der Ansprüche 1-5, wobei das Vernetzungsreagenz mindestens einen Substituenten nach folgender Formel 2 enthält 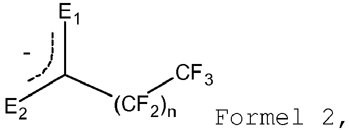 wobei n = 0-20.

7. Verfahren nach einem der Ansprüche 1-6, wobei das Vernetzungsreagenz Bismut oder Zinn umfasst und mindestens einen Substituenten mit nachfolgender Struktur enthält: 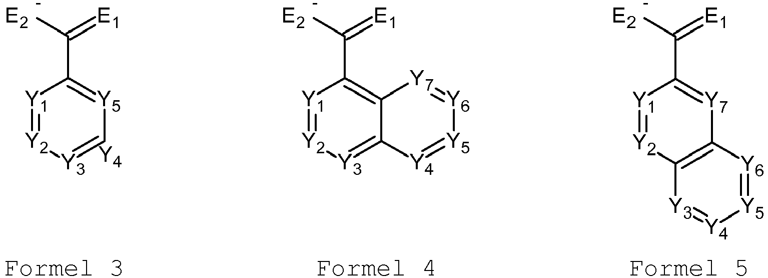 wobei Yₘ mit m von 1-7 unabhängig voneinander ausgesucht sein können aus der Gruppe umfassend C-H, C-D, C-F, C-CF₃, C-NO₂, C-CN, C-Cl, C-Br, C-CN₃, C-OCN, C-NCO, C-CNO, C-SCN, C-NCS, C-SeCN.

8. Verfahren nach einem der Ansprüche 1-7, wobei das Vernetzungsreagenz mindestens einen Substituenten umfasst, welcher ausgewählt ist aus der Gruppe 2-(Trifluoromethyl)benzoat; 3,5-Difluorobenzoat; 3-Hydroxy-2,4,6-triiodobenzoat; 3-Fluoro-4-methylbenzoat; 3-(Trifluoromethoxy)benzoat; 4-(Trifluoromethoxy)benzoat; 4-Chloro-2,5-difluorobenzoat; 2-Chloro-4,5-difluorobenzoat; 2,4,5-Trifluorobenzoat; 2-Fluorobenzoat; 4-Fluorobenzoat; 2,3,4-Trifluorobenzoat; 2,3,5-Trifluorobenzoat; 2,3-Difluorobenzoat; 2,4-Bis(trifluoromethyl)benzoat; 2,4-Difluorobenzoat; 2,5-Difluorobenzoat; 2,6-Bis(trifluoromethyl)benzoat; 2,6-Difluorobenzoat; 2-Chloro-6-fluorobenzoat; 2-Fluoro-4-(trifluoromethyl)benzoat; 2-Fluoro-5-(trifluoromethyl)benzoat; 2-Fluoro-6-(trifluoromethyl)benzoat; 3,4,5-Trifluorobenzoat; 3,4-Difluorobenzoat; 3,5-Bis(trifluoromethyl)benzoat; 3-(Trifluoromethyl)benzoat; 3-Chloro-4-fluorobenzoat; 3-Fluoro-5-(trifluoromethyl)benzoat; 3-Fluorobenzoat; 4-Fluoro-2-(trifluoromethyl)benzoat; 4-Fluoro-3-(trifluoromethyl)benzoat; 5-Fluoro-2-methylbenzoat; 2-(Trifluoromethoxy)benzoat; 2,3,5-Trichlorobenzoat; 4-(Trifluoromethyl)benzoat; Pentafluorobenzoat; 2,3,4,5-Tetrafluorobenzoat; 2,3,5,6-Tetrafluoro-4-(trifluoromethyl)benzoat; 2-Fluor-Phenylacetat; 3-Fluor-Phenylacetat; 4-Fluor-Phenylacetat; 2,3-Difluor-Phenylacetat; 2,4-Difluor-Phenylacetat; 2,6-Difluor-Phenylacetat; 3,4-Difluor-Phenylacetat; 3,5-Difluor-Phenylacetat; Pentafluor-Phenylacetat; 2-Chloro-6-fluor-Phenylacetat; 2-Chloro-3,6-difluor-Phenylacetat; 3-Chloro-2,6-difluor-Phenylacetat; 3-Chloro-4-fluor-Phenylacetat; 5-Chloro-2-fluor-Phenylacetat; 2,3,4-Trifluor-Phenylacetat; 2,3,5-Trifluor-Phenylacetat; 2,3,6-Trifluor-Phenylacetat; 2,4,5-Trifluor-Phenylacetat; 2,4,6-Trifluor-Phenylacetat; 3,4,5-Trifluor-Phenylacetat; 3-Chloro-2-fluor-Phenylacetat; α-Fluor-Phenylacetat; 4-Chloro-2-fluor-Phenylacetat; 2-Chloro-4-fluor-Phenylacetat; α,α-Difluor-Phenylacetat; Ethyl 2,2-Difluor-2-phenylacetate; Methyl-trifluoroacetat; Allyl-trifluoroacetat; Ethyl-trifluoroacetat; Isopropyl-trifluoroacetat; 2,2,2-Trifluoroethyl-trifluoroacetat; Difluoroacetat; Trifluoroacetat; Methyl-chlorodifluoroacetat; Ethylbromodifluoroacetat; Chlorodifluoroacetat; Ethylchlorofluoroacetat; Ethyl-difluoroacetat; (3-Chlorophenyl)-difluoracetat; (3,5-Difluorophenyl)-difluoroacetat; (4-Butylphenyl)difluoroacetat; (4-tert-Butylphenyl)difluoroacetat; (3,4-Dimethylphenyl)-difluoroacetat; (3-Chloro-4-fluorophenyl)-difluoroacetat; (4-Chlorophenyl)-difluoroacetat; 2-Biphenyl-3',5'-difluoroacetat; 3-Biphenyl-3',5'-difluoroacetat; 4-Biphenyl-3',5'-difluoroacetat; 2-Biphenyl-3',4'-difluoroacetat; 3-Biphenyl-3',4'-difluoroacetat; 4-Biphenyl-3',4'-difluoroacetat und 2,2-Difluoro-propionat

9. Verfahren nach einem der Ansprüche 1-8, wobei das Vernetzungsreagenz Bismut oder Zinn enthält und mindestens einer seiner Substituenten ausgewählt ist aus der Gruppe umfassend 2,6-difluorobenzoat, 4-fluorobenzoat, 3-fluorobenzoat, 3,5-difluorobenzoat, 3,4,5-trifluorobenzoat, 3,5-bis(trifluoromethyl)benzoat, perfluorobenzoat, 4-perfluorotoluat oder Mischungen daraus.

10. Verfahren nach einem der Ansprüche 1-9, wobei das Grundgerüst R_{HTL} des organischen Lochleiters ausgesucht ist aus der Gruppe umfassend C20 - C200 Triarylamin-basierte Lochleiter, Thiophen-haltiger Derivaten davon oder Mischungen daraus.

11. Verfahren nach einem der Ansprüche 1-10, wobei das Vernetzungsreagenz ein substituierter oder nicht substituierter Triaryl-Bismutkomplex ist.

12. Verfahren nach einem der Ansprüche 1-11, wobei das Vernetzungsreagenz und die organische Matrixverbindung mittels einer Temperaturbehandlung in einem Bereich von größer oder gleich 50°C und kleiner oder gleich 300°C auf dem Substrat zur Reaktion gebracht werden.

13. Verfahren nach einem der Ansprüche 1-12, wobei die funktionalisierte organische Matrixverbindung einen weiteren Anteil von größer oder gleich 0 Gewichts-% und kleiner oder gleich 50 Gewichts-% nicht funktionalisierter Matrixverbindung umfasst.

14. Organisch elektrisches Bauteil umfassend mindestens eine lochleitende elektrische Schicht, hergestellt nach einem Verfahren nach einem der Ansprüche 1-13.

15. Verwendung eines Bauteils nach Anspruch 14 als organische Solarzelle, organischen Transistor, einem licht-emittierenden, organischen Bauteil, einer organischen Leuchtdiode und/oder einer organischen licht-emittierenden elektrochemischen Zelle.

## Claims

1. Method for producing hole-transporting electrical layers, where a functionalized organic matrix compound is reacted with at least one crosslinking reagent on a substrate to form compounds of relatively high molecular mass, where the crosslinking reagent comprises at least one metal atom from groups 13-15 and at least one organic ligand, **characterized in that**
the functionalized organic matrix compound conforms to formula 1 below 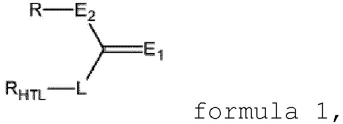 where
L is a bond or is selected from the group encompassing substituted or nonsubstituted, saturated or unsaturated C1-C50 alkyl, aryl, polyethylene glycol, polyethylenediamine, polyester, polyurethane, polyvinylidenephenyl chains or mixtures thereof;
E₁, E₂ independently of one another may be oxygen, sulfur, selenium, NH or NE₃, where E₃ is selected from the group encompassing substituted or nonsubstituted alkyl or aryl, and E₃ may be joined to R;
R is selected from the group encompassing H, D, C1-C10 alkylsilyl or aryl-silyl esters, fluorinated or nonfluorinated branched or unbranched C1-C10 alkyl, aryl or heteroaryl,
R_{HTL} is the base structure of an organic hole transporter.

2. Method according to Claim 1, where E₁ and E₂ from formula 1 are oxygen.

3. Method according to Claim 1 or 2, where the crosslinking reagent comprises metal atoms from the group consisting of bismuth, tin, lead or mixtures thereof.

4. Method according to any of Claims 1-3, where the crosslinking reagent comprises bismuth or tin and at least one ligand of the crosslinking reagent is selected from the group encompassing substituted or nonsubstituted C1-C200 aryl, alkyl, alkoxy, cycloalkyl, arylenes, haloaryl, heteroaryl, heteroarylenes, heterocycloalkylenes, heterocycloalkyl, haloheteroaryl, alkenyl, haloalkenyl, alkynyl, haloalkynyl, ketoaryl, haloketoaryl, ketoheteroaryl, ketoalkyl, haloketoalkyl, ketoalkenyl, haloketoalkenyl, and, in the case of appropriate radicals, one or more nonadjacent CH₂ groups independently of one another may be replaced by -O-, -S-, -NH-, -CO-, -COO-, -OCO-, -OCO-O-, -SO₂-, -S-CO-, -CO-S-, -C=Cor -C=C-, specifically such that O and/or S atoms are not joined directly to one another.

5. Method according to any of Claims 1-4, where the base structure of the organic hole transporter is selected from the group encompassing PEDOT (poly(3,4-ethylenedioxythiophene)), PVK (poly(9-vinylcarbazole)), PTPD (poly(N,N'-bis(4-butylphenyl)-N,N'-bis(phenyl)benzidine)), PANI (polyaniline), P3HT (poly(3-hexylthiophene)) or mixtures thereof.

6. Method according to any of Claims 1-5, where the crosslinking reagent comprises at least one substituent according to formula 2 below 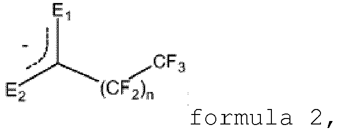 where n = 0-20.

7. Method according to any of Claims 1-6, where the crosslinking reagent comprises bismuth or tin and comprises at least one substituent with the structure below: 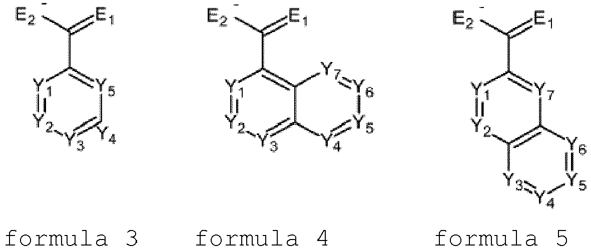 where Yₘ with m from 1-7 independently of one another may be selected from the group encompassing C-H, C-D, C-F, C-CF₃, C-NO₂, C-CN, C-Cl, C-Br, C-CN₃, C-OCN, C-NCO, C-CNO, C-SCN, C-NCS, C-SeCN.

8. Method according to any of Claims 1-7, where the crosslinking reagent comprises at least one substituent selected from the group of 2-(trifluoromethyl)benzoate; 3,5-difluorobenzoate; 3-hydroxy-2,4,6-triiodobenzoate; 3-fluoro-4-methylbenzoate; 3-(trifluoromethoxy)benzoate; 4-(trifluoromethoxy)benzoate; 4-chloro-2,5-difluorobenzoate; 2-chloro-4,5-difluorobenzoate; 2,4,5-trifluorobenzoate; 2-fluorobenzoate; 4-fluorobenzoate; 2,3,4-trifluorobenzoate; 2,3,5-trifluorobenzoate; 2,3-difluorobenzoate; 2,4-bis(trifluoromethyl)benzoate; 2,4-difluorobenzoate; 2,5-difluorobenzoate; 2,6-bis(trifluoromethyl)benzoate; 2,6-difluorobenzoate; 2-chloro-6-fluorobenzoate; 2-fluoro-4-(trifluoromethyl)benzoate; 2-fluoro-5-(trifluoromethyl)benzoate; 2-fluoro-6-(trifluoromethyl)-benzoate; 3,4,5-trifluorobenzoate; 3,4-difluorobenzoate; 3,5-bis(trifluoromethyl)benzoate; 3-(trifluoromethyl)benzoate; 3-chloro-4-fluorobenzoate; 3-fluoro-5-(trifluoromethyl)benzoate; 3-fluorobenzoate; 4-fluoro-2-(trifluoromethyl)benzoate; 4-fluoro-3-(trifluoromethyl)benzoate; 5-fluoro-2-methylbenzoate; 2-(trifluoromethoxy)benzoate; 2,3,5-trichlorobenzoate; 4-(trifluoromethyl)benzoate; pentafluorobenzoate; 2,3,4,5-tetrafluorobenzoate; 2,3,5,6-tetrafluoro-4-(trifluoromethyl)benzoate; 2-fluorophenyl acetate; 3-fluorophenyl acetate; 4-fluorophenyl acetate; 2,3-difluorophenyl acetate; 2,4-difluorophenyl acetate; 2,6-difluorophenyl acetate; 3,4-difluorophenyl acetate; 3,5-difluorophenyl acetate; pentafluorophenyl acetate; 2-chloro-6-fluorophenyl acetate; 2-chloro-3,6-difluorophenyl acetate; 3-chloro-2,6-difluorophenyl acetate; 3-chloro-4-fluorophenyl acetate; 5-chloro-2-fluorophenyl acetate; 2,3,4-trifluorophenyl acetate; 2,3,5-trifluorophenyl acetate; 2,3,6-trifluorophenyl acetate; 2,4,5-trifluorophenyl acetate; 2,4,6-trifluorophenyl acetate; 3,4,5-trifluorophenyl acetate; 3-chloro-2-fluorophenyl acetate; α-fluorophenyl acetate; 4-chloro-2-fluorophenyl acetate; 2-chloro-4-fluorophenyl acetate; α,α-difluorophenyl acetate; ethyl 2,2-difluoro-2-phenyl acetate; methyl trifluoroacetate; allyl trifluoroacetate; ethyl trifluoroacetate; isopropyl trifluoroacetate; 2,2,2-trifluoroethyl trifluoroacetate; difluoroacetate; trifluoroacetate; methyl chlorodifluoroacetate; ethyl bromodifluoroacetate; chlorodifluoroacetate; ethyl chlorofluoroacetate; ethyl difluoroacetate; (3-chlorophenyl)difluoroacetate; (3,5-difluorophenyl)difluoroacetate; (4-butylphenyl)difluoroacetate; (4-tert-butylphenyl)difluoroacetate; (3,4-dimethylphenyl)difluoroacetate; (3-chloro-4-fluorophenyl)difluoroacetate; (4-chlorophenyl)difluoroacetate; 2-biphenylyl-3',5'-difluoroacetate; 3-biphenylyl-3',5'-difluoroacetate; 4-biphenylyl-3',5'-difluoroacetate; 2-biphenylyl-3',4'-difluoroacetate; 3-biphenylyl-3',4'-difluoroacetate; 4-biphenylyl-3',4'-difluoroacetate, and 2,2-difluoropropionate.

9. Method according to any of Claims 1-8, where the crosslinking reagent comprises bismuth or tin and at least one of its substituents is selected from the group encompassing 2,6-difluorobenzoate, 4-fluorobenzoate, 3-fluorobenzoate, 3,5-difluorobenzoate, 3,4,5-trifluorobenzoate, 3,5-bis(trifluoromethyl)benzoate, perfluorobenzoate, 4-perfluorotoluate or mixtures thereof.

10. Method according to any of Claims 1-9, where the base structure R_{HTL} of the organic hole transporter is selected from the group encompassing C20-C200 triarylamine-based hole transporters, thiophene-containing derivatives thereof or mixtures thereof.

11. Method according to any of Claims 1-10, where the crosslinking reagent is a substituted or nonsubstituted triaryl-bismuth complex.

12. Method according to any of Claims 1-11, where the crosslinking reagent and the organic matrix compound are reacted on the substrate by means of a temperature treatment in a range of greater than or equal to 50°C and less than or equal to 300°C.

13. Method according to any of Claims 1-12, where the functionalized organic matrix compound comprises a further fraction of greater than or equal to 0 weight% and less than or equal to 50 weight% of nonfunctionalized matrix compound.

14. Organoelectric component comprising at least one hole-transporting electrical layer, produced by a method according to any of Claims 1-13.

15. Use of a component according to Claim 14 as an organic solar cell, organic transistor, light-emitting organic component, organic light-emitting diode and/or organic light-emitting electrochemical cell.

## Revendications

1. Procédé de production de couche électrique conductrice à trous,
dans lequel on met un composé de matrice organique fonctionnalisé à réagir sur au moins un réactif de réticulation sur un substrat, en formant des composés de grand poids moléculaire, dans lequel le réactif de réticulation comprend au moins un atome métallique des groupes 13 à 15 et au moins un liguant organique, **caractérisé en ce que**
le composé de matrice organique fonctionnalisé correspond à la formule 1 suivante 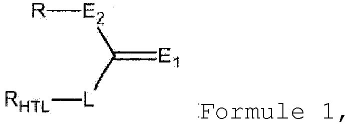 dans laquelle
L est une liaison ou est choisi dans le groupe comprenant des chaînes Alcoyle, Aryle, Polyéthylèneglycol, Polyéthylènediamine, Polyester, Polyuréthane, Polyvinylidenphényle en C1 à C50, saturé ou insaturé, substitué ou non substitué ou leurs mélanges ;
E₁, E₂ peuvent être, indépendamment l'un de l'autre, oxygène, soufre, sélénium, NH ou NE₃, E₃ étant choisi dans le groupe comprenant Alcoyle ou Aryle, substitué ou non substitué, E₃ pouvant être relié à R ;
R est choisi dans le groupe comprenant H, D, éther silylique d'Alcoyle en C1 à C10 ou d'Aryle, Alcoyle en C1 à C10 ramifié ou non ramifié, fluoré ou non fluoré, Aryle ou Hétéroaryle, R_{HTL} est le squelette de base d'un conducteur organique de trous.

2. Procédé suivant la revendication 1, dans lequel E₁ et E₂, dans la formule 1, sont oxygène.

3. Procédé suivant la revendication 1 ou 2, dans lequel le réactif de réticulation comprend des atomes métalliques du groupe constitué du Bismuth, de l'Etain, du Plomb ou leurs mélanges.

4. Procédé suivant l'une des revendications 1 à 3, dans lequel le réactif de réticulation comprend du Bismuth ou de l'Etain et au moins un liguant du réactif de réticulation est choisi dans le groupe comprenant Aryle, Alcoyle, Alcoxy, Cycloalcoyle, Arylène, Halogènoaryle, Hétéroaryle, Hétéroarylène, Hétérocycloalcoylène, Hétérocycloalcoyle, Halogénohétéroaryle, Alcényle, Halogénoalcényle, Alcinyle, Halogénoalcinyle, Cétoaryle, Halogénocétoaryle, Cétohétéroaryle, Cétoalcoyle, Halogénocétoacoyle, Cétoalcényle, Halogénocétoalcényle, en C1 à C200, substitué ou non substitué, dans lequel, dans des restes appropriés, un ou plusieurs groupes CH₂ non voisins peuvent être remplacés indépendamment l'un de l'autre par -O-, -S-, -NH- -CO-, -COO-, -OCO-, -OCO-O-, -SO₂-, -S-CO-, -CO-S-, -C=C- ou -C=C- et cela de façon à ce que des atomes de O et/ou de S ne soient pas reliés directement.

5. Procédé suivant l'une des revendications 1 à 4, dans lequel le squelette de base du conducteur à trous organique est choisi dans le groupe comprenant PEDOT (Poly(3,4-éthylènedioxythiophène)), PVK (Poly(9-vinylecarbazol)), PTPD (Poly(N,N'-bis(4-butyphényl)-N,N'-bis(phényl)benzidine), PANI(Polyaniline), P3HT(Poly(3-hexylthiophène) ou leurs mélanges.

6. Procédé suivant l'une des revendications 1 à 5, dans lequel le réactif de réticulation comprend au moins un substituant selon la formule 2 suivante 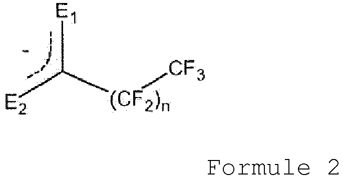 dans laquelle n = 0 à 20.

7. Procédé suivant l'une des revendications 1 à 6, dans lequel le réactif de réticulation comprend du Bismuth ou de l'Etain et contient au moins un substituant de formule suivante : 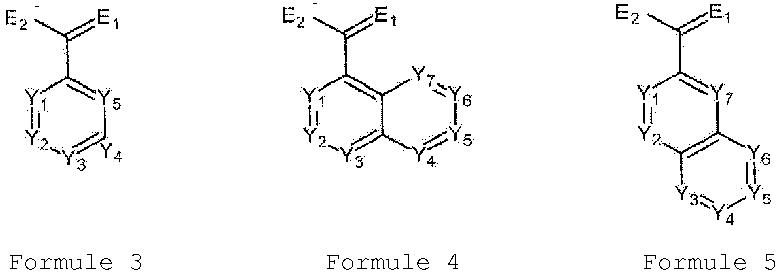 dans lesquelles Yₘ avec m allant de 1 à 7 peuvent être choisis indépendamment les uns des autres dans le groupe comprenant C-H, C-D, C-F, C-CF₃, C-NO₂, C-CN, C-C1, C-Br, C-CN₃, C-OCN, C-NCO, C-CNO, C-SCN, C-NCS, C-SeCN.

8. Procédé suivant l'une des revendications 1 à 7, dans lequel le réactif de réticulation comprend au moins un substituant, qui est choisi dans (Trifluorométhyle)benzoate de groupe 2; 3,5-Difluorobenzoate ; 3-Hydroxy-2,4,6-triiodoenzoate ; 3-Fluoro-4-méthylbenzoate ; 3-(Trifluorométhoxy)benzoate ; 4-(Trifluorométhoxy)benzoate ; 4-Chloro-2,5-difluorobenzoate ; 2-Chloro-4,5-difluorobenzoate ; 2,4,5-Trifluorobenzoate ; 2-Fluorobenzoate ; 4-Fluorobenzoate ; 2,3,4-Trifluorobenzoate ; 2,3,5-Trifluorobenzoate ; 2,3-Difluorobenzoate ; 2,4-Bis(trifluorométhyle)benzoate ; 2,4-Difluorobenzoate ; 2,5-Difluorobenzoate ; 2,6-Bis(trifluorométhyle)benzoate ;2,6-Difluorobenzoate ; 2-Chloro-6-fluorobenzoate ; 2-Fluoro-4-(trifluorométhyle)benzoate ; 2-Fluoro-5-(trifluorométhyle)benzoate ; 2-Fluoro-6-(trifluorométhyle)benzoate ; 3,4,5-Trifluorobenzoate ; 3,4-Difluorobenzoate ; 3,5-Bis(trifluorométhyle)benzoate ; 3-(Trifluorométhyle)benzoate ; 3-Chloro-4-fluorobenzoate ; 3-Fluoro-5-(trifluorométhyle)benzoate ; 3-Fluorobenzoate ; 4-Fluoro-2-(trifluorométhyle)benzoate ; 4-Fluoro-3-(trifluorométhyle)benzoate ; 5-Fluoro-2-2-(Trifluorométhoxy)benzoate ; 2,3,5-Trichlorobenzoate ; 4-(Trifluorométhyle)benzoate ; Pentafluorobenzoate ; 2,3,4,5-Tetrafluorobenzoate ; 2,3,5,6-Tetrafluoro-4-(trifluorométhyle)benzoate; 2-Fluoro-Phénylacétate ; 3-Fluoro-Phénylacétate ; 4-Fluoro-Phénylacétate ; 2,3-Difluoro-Phénylacétate ; 2,4-Difluoro-Phénylacétate ; 2,6-Difluoro-Phénylacétate ; 3,4-Difluoro-Phénylacétate ; 3,5-Difluoro-Phénylacétate ; Pentafluoro-Phénylacétate ; 2-Chloro-6-fluoro-Phénylacétate ; 2-Chloro-3, 6-difluoro-Phénylacétate ; 3-Chloro-2, 6-difluoro-Phénylacétate ; 3-Chloro-4-fluoro-Phénylacétate ; 5-Chloro-2-fluoro-Phénylacétate ; 2,3,4-Trifluoro-Phénylacétate ; 2,3,5-Trifluoro-Phénylacétate ; 2,3,6-Trifluoro-Phénylacétate ; 2,4,5-Trifluoro-Phénylacétate ; 2,4,6-Trifluoro-Phénylacétate; 3,4,5-Trifluoro-Phénylacétate; 3-Chloro-2-fluoro-Phénylacétate; α-Fluoro-Phénylacétate; 4-Chloro-2-fluoro-Phénylacétate; 2-Chloro-4-fluoro-Phénylacétate; α,α-Difluoro-Phénylacétate; Ethyle 2,2-Difluoro-2-phénylacétate; Méthyle-trifluoroacétate; Allyl-trifluoroacétate; Ethyle-trifluoroacétate ; Isopropyl-trifluoroacétate ; 2,2,2-Trifluoroéthyle-trifluoroacétate ; Difluoroacétate ; Trifluoroacétate ; Méthyle-chlorodifluoroacétate ; Ethyle-bromodifluoroacétate ; Chlorodifluoroacétate ; Ethyle-chlorofluoroacétate ; Ethyle-difluoroacétate ; (3-Chlorophényle)-difluoroacétate ; (3,5-Difluorophényle)-difluoroacétate ; (4-Butylphényle)difluoroacétate; (4-tert-Butylphényle)difluoroacétate; (3,4-Dimethylphényle)-difluoroacétate; (3-Chloro-4-fluorophényle)-difluoroacétate; (4-Chlorophényle)-difluoroacétate ; 2-Biphényle-3',5'-difluoroacétate ; 3-Biphényle-3',5'-difluoroacétate; 4-Biphényle-3',5'-difluoroacétate; 2-Biphényle-3',4'-difluoroacétate; 3-Biphényle-3',4'-difluoroacétate; 4-Biphényle-3',4'-difluoroacétate et 2,2-Difluoro-propionate.

9. Procédé suivant l'une des revendications 1 à 8, dans lequel le réactif de réticulation contient du Bismut ou de l'Etain et au moins l'un de ses substituants est choisi dans le groupe comprenant 2,6-difluorobenzoate, 4-fluorobenzoate, 3-fluorobenzoate, 3,5-difluorobenzoate, 3,4,5-trifluorobenzoate, 3,5-bis(trifluorométhyle)benzoate, perfluorobenzoate, 4-perfluorotoluate ou leurs mélanges.

10. Procédé suivant l'une des revendications 1 à 9, dans lequel le squelette de base R_{HTL} du conducteur organique à trous est choisi dans le groupe comprenant un conducteur à trous à base de Triarylamine en C20 à C200, ses dérivés Thiophéniques ou leurs mélanges.

11. Procédé suivant l'une des revendications 1 à 10, dans lequel le réactif de réticulation est un complexe de Bismuth Triaryle substitué ou non substitué.

12. Procédé suivant l'une des revendications 1 à 11, dans lequel le réactif de réticulation et le composé organique de matrice sont mis en réaction sur le substrat au moyen d'un traitement en température dans une plage supérieure ou égale à 50°C et inférieure ou égale à 300°C.

13. Procédé suivant l'une des revendications 1 à 12, dans lequel le composé organique de matrice fonctionnalisé comprend une autre proportion supérieure ou égale à 0% en poids et inférieure ou également à 50% en poids de composé de matrice non fonctionnalisé.

14. Pièce électrique organiquement, comprenant au moins une couche électrique conductrice à trous produite par un procédé suivant l'une des revendications 1 à 13.

15. Utilisation d'une pièce suivant la revendication 14 comme cellule solaire organique, transistor organique, pièce organique émettant de la lumière, diode électro-organique électroluminescente et/ou cellule électrochimique organique émettant de la lumière.
